# EUROPEAN PATENT APPLICATION

(11) **EP 0 584 402 A1**
(43) Date of publication of application: **02.03.1994**
(21) Application number: 92121189.2
(22) Date of filing: 11.12.1992
(51) Int. Cl.: H03K 17/693, G01R 19/165

(54) **Circuit calculating the maximum value**

(30) Priority: 26.08.1992 JP 252048/92
(71) Applicant: YOZAN INC., Tokyo 155 (JP); SHARP KABUSHIKI KAISHA, Osaka 545 (JP)
(72) Inventor: Shu, Guoling, Setagaya-ku, Tokyo 155 (JP); Yang, Weikang, Setagaya-ku, Tokyo 155 (JP); Wongwarawipat, Wiwat, Setagaya-ku, Tokyo 155 (JP); Takatori, Sunao, Setagaya-ku, Tokyo 155 (JP); Yamamoto, Makoto, Setagaya-ku, Tokyo 155 (JP)
(74) Representative: Grünecker, Kinkeldey, Stockmair & Schwanhäusser Anwaltssozietät

(57) **Abstract**

A circuit calculating the maximum value, wherein the drains of a plural number of nMOS (T1,T2,...) are connected to a power source (Vcc), the sources are grounded through a high resistance (R), input voltage (X,Y,...) is connected to the gate of each nmos (T1,T2,...), and the source of each nMOS (T1,T2,...) is connected to the output terminal (Do).

## Description

### -FIELD OF THE INVENTION-

The present invention relates to a circuit outputting the maximum value of a plural number of inputs.

### -BACKGROUND OF THE INVENTION-

Conventionally, a complicated operation, such as the calculation of the maximum value in a plural number of data, has been often realized by a digital computer, and it has been necessary a rather large structure using plural steps of comparison circuits and multiplexer.

### -SUMMARY OF THE INVENTION-

The present invention is invented so as to solve the above problem and has an object to provide a small size circuit calculating the maximum value in high speed.

The circuit calculating the maximum value according to the present invention uses switching of the characteristic of a plural number of nMOS. It connects the source of nMOS to the common output, inputs the input voltage to the gate of each nMOS, the only nMOS received the maximum input becomes conductive, generating voltage on the source sides of other nMOS and the nMOS received inputs excepting the maximum input have breaking.

### BRIEF DESCRIPTION OF THE DRAWINGS

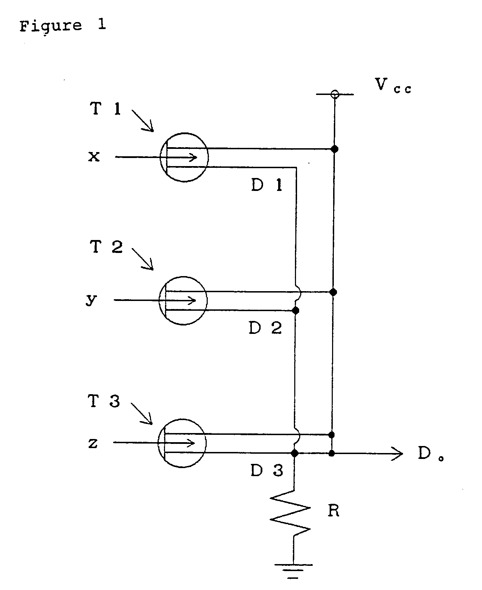

Figure 1 shows a circuit of an embodiment according to the present invention
T1, T2 and T3 are nMOS.
x, y and z are input voltage.
D1, D2 and D3 are source follower outputs.
Do is the common output.
Vcc is a power source.
R is a high speed resistance.

### -PREFERRED EMBODIMENT OF THE INVENTION-

Hereinafter an embodiment of the circuit calculating the maximum value is described with reference to the attached drawings.

In Figure 1, the circuit calculating the maximum value comprises a plural number of nMOS ("T1" "T2" and "T3") in parallel. Input voltage "x", "y" and "z" are input to T1, T2 and T3, respectively. T1, T2 and T3 comprise outputs source follower outputs D1, D2 and D3, respectively. These outputs are connected to the common output Do.

Each nMOS has the independent characteristic as below when an output equivalent to the input voltage is generated in the source.

$\text{D1=x}$
$\text{D2=y}$
$\text{D3=z.}$

When the condition is x> y and x> z, T1 has D1 equivalent to x, therefore, T2 and T3 have source voltage higher than their gate voltage. Consequently, T2 and T3 have breaking and D1 itself is Do. When y or z is the maximal value, the progress is the same and the maximum input voltage is Do.

The above embodiment connects three nMOS in parallel. It is possible to output the maximal input voltage between two or within 4 or more by connecting nMOS by 2 pieces, 4 pieces or more, similarly above.

The necessary time for obtaining these outputs is almost equal to the corresponding time of one nMOS. This is exceedingly higher speed than the case of operation by digital circuit. The size of the circuit is very small, as is clear from the structure.

As mentioned, the circuit calculating the maximum value is small size and high speed corresponding because the maximum value of each nMOS is generated in the common output by connecting the source follower output of nMOS to the common output.

## Claims

1. A circuit calculating the maximum value, wherein drains of a plural number of nMOS are connected to a power source, sources are grounded through high resistance, input voltage is connected to gate of each nmos, and said source of each nMOS is connected to output terminal.
